# EUROPÄISCHE PATENTANMELDUNG

(11) **EP 3 062 328 A2**
(43) Veröffentlichungstag der Anmeldung: **31.08.2016**
(21) Anmeldenummer: 16155236.9
(22) Anmeldetag: 11.02.2016
(51) Int. Cl.: H01H 50/02, H02B 1/052, H05K 7/14

(54) **GEHÄUSE FÜR EINE ELEKTROBAUGRUPPE ZUR MONTAGE AUF EINER TRAGESCHIENE SOWIE KOMMUNIKATIONSEINHEIT**

(30) Priorität: 26.02.2015 DE 102015203497
(71) Anmelder: Power Plus Communications AG, 68167 Mannheim (DE)
(72) Erfinder: Veselcic, Marko, 67122 Altrip (DE); Straube, Peter, 68165 Mannheim (DE); Sille, Inga, 68159 Mannheim (DE)
(74) Vertreter: Patent- und Rechtsanwälte Ullrich & Naumann

(57) **Zusammenfassung**

Es ist ein Gehäuse für eine Elektrobaugruppe, insbesondere für ein SmartMeter-Gateway, zur Montage auf einer Trageschiene (2), insbesondere auf einer Hutschiene, offenbart. Das Gehäuse (1) weist mehrere Außenwandungen (5, 6, 7, 8, 9) auf, die gemeinsam einen Raum innerhalb des Gehäuses (1) begrenzen. In dem Gehäuse (1) ist eine Trennwandung (19) angeordnet, die sich von einer der mehreren Außenwandungen (5, 6, 7, 8, 9) zu einer anderen der mehreren Außenwandungen (5, 6, 7, 8, 9) erstreckt und die den durch die mehreren Außenwandungen (5, 6, 7, 8, 9) begrenzten Raum in einen ersten Bereich (17) und einen zweiten Bereich (18) unterteilt. Die den ersten Bereich (17) begrenzenden Wandungen (5, 6, 7, 8, 9, 19) sind dabei zum Einhalten einer ersten Schutzart und die den zweiten Bereich (18) begrenzenden Wandungen (5, 6, 7, 8, 9, 19) zum Einhalten einer zweiten Schutzart ausgebildet, wobei die erste Schutzart ungleich der zweiten Schutzart ist.

Es ist ferner eine Kommunikationseinheit offenbart, die ein entsprechendes Gehäuse (1) und eine in diesem Gehäuse angeordnete Elektrobaugruppe umfasst. Dabei ist die Elektrobaugruppe auf mehreren Platinen (28) aufgebaut.

## Beschreibung

Die Erfindung betrifft ein Gehäuse für eine Elektrobaugruppe, insbesondere für ein SmartMeter-Gateway, zur Montage auf einer Trageschiene, insbesondere auf einer Hutschiene, wobei das Gehäuse mehrere Außenwandungen aufweist, die gemeinsam einen Raum innerhalb des Gehäuses begrenzen. Des Weiteren betrifft die Erfindung eine Kommunikationseinheit mit einem entsprechenden Gehäuse und einer in dem Gehäuse angeordneten Elektrobaugruppe, insbesondere einem SmartMeter-Gateway.

Zum Schutz einer Elektrobaugruppe innerhalb eines Gehäuses, beispielsweise gegen Manipulation, vor Staub oder vor Feuchtigkeit, und zum Schutz für Personen, beispielsweise vor gefährlichen Spannungen, ist es in der Praxis üblich, dass das Gehäuse einer Schutzart genügen muss. Eine der gängigsten Definitionen von Schutzarten ist durch die sogenannten "International Protection Codes" (kurz: IP-Codes) gegeben, die beispielsweise durch DIN EN 60529 oder ISO 20653 definiert sind. Ein IP-Code setzt sich aus den beiden Buchstaben IP und aus zwei diesen Buchstaben folgenden Kennziffern zusammen. Die erste Kennziffer gibt an, welchen Schutz ein jeweiliges Gehäuse gegen Fremdkörper bzw. Berührung aufweist; die zweite Kennziffer gibt an, welchen Schutz ein Gehäuse gegen Wasser bietet. Eine der beiden Kennziffern kann durch ein "X" ersetzt werden, wenn zu dieser Kennziffer keine Angabe gemacht werden muss oder soll. Gängig ist beispielsweise ein IP3X-Gehäuse, das einen Schutz gegen Fremdkörper mit einem Durchmesser ab 2,5 mm bietet (erste Kennziffer) und bei dem zum Schutz gegen Wasser keine Angaben gemacht sind (zweite Kennziffer). Dies bedeutet umgekehrt, dass in den Wandungen des Gehäuses keine Öffnung vorhanden sein darf, die einen Zugang in das Innere des Gehäuses freigibt und die einen Durchmesser (bei runden Öffnungen) oder eine Breite (beispielsweise bei quadratischen oder rechteckigen Öffnungen) größer als 2,5 mm aufweist. Derartige Öffnungen können beispielsweise durch Lüftungslöcher gebildet sein, durch die in dem Gehäuse durch die Elektrobaugruppe entstehende Wärme aus dem Gehäuse entweichen kann.

Einige dieser Gehäuse - auf die sich auch die vorliegende Erfindung bezieht - sind zur Montage auf einer Trageschiene ausgebildet. Die in Europa vermutlich am weitesten verbreitete Tragschiene ist als Hutschiene bekannt und ist nach EN 50022 genormt. Die Abmessungen der zugehörigen Gehäuse sowie deren Einbaumaße sind in Deutschland nach DIN 43880 genormt. Hutschienen finden häufig in Elektroverteilern Anwendung und tragen die Gehäuse der meisten oder gar aller in dem Elektroverteiler installierten Geräte, wie Sicherungsautomaten, Fehlerstromschutzschalter, Überspannungsableiter, Steuergeräte, Zeitschaltuhren, SmartMeter oder SmartMeter-Gateways. Auf letztere wird nachfolgend als Beispiel für eine Kommunikationseinheit näher eingegangen.

Ein SmartMeter-Gateway stellt eine Verbindung zwischen einer Weitbereichsschnittstelle, beispielsweise durch Power Line Communication (PLC) implementiert, und weiteren Schnittstellen her, über die unter anderem ein oder mehrere SmartMeter (elektronischer Zähler, meist für elektrische Energie, Wasser, Gas oder Wärme) verbunden sind. In Deutschland enthält das Gesetz über die Elektrizitäts- und Gasversorgung (EnWG) und dort insbesondere die §§ 21 e, 21f und 21i gewisse Vorgaben für die Funktion eines SmartMeter-Gateways, die in einem Schutzprofil und einer Technischen Richtlinie des Bundesamts für Sicherheit in der Informationstechnik (BSI) weiter konkretisiert sind. Danach muss ein SmartMeter-Gateway Firewall-Funktionalitäten implementieren und eine logische Trennung der jeweiligen Netze (LMN (Local Metrological Network), HAN (Home Area Network) und WAN (Wide Area Network)) gewährleisten. Im LMN ist der/sind die SmartMeter angeordnet. Über das HAN kann ein Endkunde Verbrauchs- oder Einspeisewerte auslesen oder ein Techniker kann den Systemstatus abfragen. Über das WAN erfolgt ein Zugriff durch verschiedene Marktteilnehmer (beispielsweise SmartMeter-Gateway-Administrator, Verteilnetzbetreiber oder Messstellenbetreiber), wobei der SmartMeter-Gateway den Zugriff auf die Daten regelt. Dabei darf eine Kommunikationsverbindung über das WAN lediglich von innen nach außen aufgebaut werden, d.h. aus dem WAN bei dem SmartMeter-Gateway ankommende Anfragen dürfen nicht beantwortet werden. Durch diese Maßnahmen soll die Manipulation von abrechnungsrelevanten Daten oder von Netzzustandsdaten verhindert und Datenschutz gewährleistet werden.

Für die gerätetechnische Umsetzung der rechtlichen Vorgaben hat das FNN (Forum Netztechnik und Netzbetrieb im VDE (Verband der Elektrotechnik, Elektronik und Informationstechnik e.V.)) das Lastenheft "FNN MS2020 - Lastenheft Konstruktion, Basiszähler und SmartMeter-Gateway" (MS2020 = Messsystem2020) veröffentlicht. Darin ist unter anderem vorgesehen, dass das Gehäuse eines SmartMeter-Gateways eine Schutzart IP3x aufweisen muss. Allerdings ist es bei einem IP3X-Gehäuse immer noch möglich, dass ein dünner Draht zur Manipulation der im Gehäuse angeordneten Elektrobaugruppe in das Gehäuse eingeführt wird.

Zur Lösung dieses Problems könnte die Schutzart erhöht werden. So könnte das Gehäuse die Schutzart IP5X erfüllen und damit gegen Staub in schädigender Menge geschützt sein. Dadurch würde eine Manipulation durch einen eingeführten Draht und eine Berührung der Elektrobaugruppe verhindert. Nachteilig daran ist allerdings, dass aus einem IP5X-Gehäuse praktisch keine Wärme nach außen abgeführt werden kann, da keine Lüftungslöcher in dem Gehäuse vorgesehen sein dürfen. Da ein SmartMeter-Gateway 24 Stunden am Tag in Betrieb sei wird, werden die Komponenten in dem Gehäuse überhitzen und es droht eine Zerstörung der Elektrobaugruppe. Zur Lösung dieses Problems könnte an der Außenseite des Gehäuses ein Kühlkörper angebracht sein, an den Wärme aus dem Inneren des Gehäuses geleitet wird und der die Wärme an die Umgebung abgibt. Dadurch wird jedoch ein ausreichend großer Kühlkörper benötigt, wodurch sich die Abmessung des Gehäuses erheblich vergrößert. Durch das Leiten der Wärme von der Elektrobaugruppe an den Kühlkörper entstehen weitere Probleme, die sich unter anderem negativ auf die Gestaltungsfreiheit beim Layout der Platinen und die Kosten auswirkt. Auch wenn sich die voranstehenden Ausführungen im Wesentlich auf ein SmartMeter-Gateway beziehen, so wird ein Fachmann ohne weiteres erkennen, dass die zuvor beschriebenen Probleme auch auf andere Kommunikationseinheiten und allgemein auf andere Elektrobaugruppen übertragbar sind.

Der vorliegenden Erfindung liegt daher die Aufgabe zugrunde, ein Gehäuse für eine Elektrobaugruppe sowie eine Kommunikationseinheit der eingangs genannten Art derart auszugestalten und weiterzubilden, dass ein guter Schutz gegen Manipulation bei gleichzeitig ausreichender Kühlmöglichkeit für die in dem Gehäuse bzw. in der Kommunikationseinheit angeordnete Elektrobaugruppe gewährleistet ist.

Erfindungsgemäß wird die voranstehende Aufgabe durch die Merkmale des Anspruchs 1 gelöst. Danach ist das in Rede stehende Gehäuse dadurch gekennzeichnet, dass in dem Gehäuse eine Trennwandung angeordnet ist, die sich von einer der mehreren Außenwandungen zu einer anderen der mehreren Außenwandungen erstreckt und die den durch die mehreren Außenwandungen begrenzten Raum in einen ersten Bereich und einen zweiten Bereich unterteilt, und dass die den ersten Bereich begrenzenden Wandungen zum Einhalten einer ersten Schutzart und die den zweiten Bereich begrenzenden Wandungen zum Einhalten einer zweiten Schutzart ausgebildet sind, wobei die erste Schutzart ungleich der zweiten Schutzart ist.

Hinsichtlich der Kommunikationseinheit ist die voranstehende Aufgabe durch die Merkmale des Anspruchs 13 gelöst.

In erfindungsgemäßer Weise ist zunächst erkannt worden, dass sehr häufig nicht alle Bestandteile einer Elektrobaugruppe, die innerhalb eines Gehäuses angeordnet sind, das gleiche Schutzniveau bedürfen. Einige Bestandteile müssen in höherem Maße vor Berührung und/oder Manipulation geschützt werden als andere. Bei einem SmartMeter-Gateway sollte beispielsweise eine Manipulation eines Sicherheitsmoduls zuverlässig verhindert werden, während der Schutz bei einem in dem SmartMeter-Gateway integrierten PLC-Modem geringer sein kann. Diese Erkenntnis wird dazu genutzt, dass in dem Gehäuse eine Trennwandung angeordnet ist, die sich von einer Wandung des Gehäuses zu einer anderen Wandung des Gehäuses erstreckt. Dadurch unterteilt die Trennwandung den in dem Gehäuse durch dessen Außenwandungen begrenzten Raum in einen ersten Bereich und einen zweiten Bereich. Die Wandungen des ersten Bereichs, d.h. die Außenwandungen des Gehäuses, die den ersten Bereich begrenzen, sowie die Trennwandung, sind derart ausgebildet, dass sie einer ersten Schutzart genügen. Die Wandungen des zweiten Bereichs, d.h. die Außenwandungen des Gehäuses, die den zweiten Bereich begrenzen, sowie die Trennwandung sind derart ausgebildet, dass sie einer zweiten Schutzart genügen. Dabei ist die erste Schutzart ungleich der zweiten Schutzart. Dadurch ist es möglich einen Teil des Gehäuses hinsichtlich guter Kühleigenschaften zu optimieren und den anderen Teil hinsichtlich eines hohen Schutzes vor Manipulation. Auf diese Weise lassen sich die eigentlich gegensätzlichen Zielsetzungen gleichzeitig innerhalb eines Gehäuses erfüllen.

Da die Trennwandung sowohl der ersten Schutzart als auch der zweiten Schutzart genügen muss, wird diese die jeweils höhere der beiden Schutzarten aufweisen. Sofern eine Außenwandung des Gehäuses sowohl zur Begrenzung des ersten Bereichs als auch zur Begrenzung des zweiten Bereichs dient, so kann diese Außenwandung in dem jeweiligen Bereich entsprechend der zu erzielenden Schutzart ausgestaltet sein. So kann diese Außenwandung beispielsweise in dem einen Bereich Lüftungslöcher aufweisen, während sie in dem anderen Bereich vollständig geschlossen ist.

Die Trennwandung ist vorzugsweise und im Wesentlichen plan ausgeführt, d.h. die Trennwandung erstreckt sich - abgesehen beispielsweise von einzelnen Erhebungen oder einer Struktur der Oberfläche - in einer Ebene. Dabei erstreckt sich die Trennwandung vorzugsweise zu allen Außenwandungen des Gehäuses, die diese Ebene der Trennwandung schneiden. Dadurch werden der erste und der zweiten Bereich in dem gesamten Gehäuse vollständig voneinander getrennt.

An den an der Trennwandung angrenzenden Außenwandungen können Haltevorrichtungen angeordnet oder ausgebildet sein, die die Trennwandung innerhalb des Gehäuses halten. In einer besonders einfachen Ausgestaltung sind Schienen in einer oder mehreren Außenwandungen angeformt, in die die Trennwandung eingeschoben werden kann. Alternativ oder zusätzlich kann die Trennwandung Haltenasen oder Haltestifte aufweisen, die beispielsweise in eine der Platinen der Elektrobaugruppe gesteckt und mit dieser verlötet sind. Auch auf diese Weise kann eine Trennwandung im Sinne der vorliegenden Erfindung realisiert sein.

Es sei darauf hingewiesen, dass es prinzipiell unerheblich ist, in welchem Größenverhältnis der erste Bereich und der zweite Bereich zueinander ausgebildet ist. So wäre denkbar, dass der erste Bereich im Wesentlichen gleich groß wie der zweite Bereich ist. Es ist aber auch denkbar, dass einer der Bereiche einen weitaus größeren Anteil des Gehäuses einnimmt als der andere Bereich. Die Aufteilung wird im Wesentlichen von dem jeweiligen Anwendungszweck des Gehäuses bestimmt sein. Es ist prinzipiell auch möglich, dass eine Trennwandung derart ausgebildet ist, dass mehrere zweite Bereiche entstehen. Es können innerhalb eines Gehäuses auch mehrere Trennwandungen im Sinne der vorliegenden Erfindung vorhanden sein.

In einer bevorzugten Ausgestaltung weist die Trennwandung Mittel zum Wärmetransport auf und/oder es sind Mittel zum Wärmetransport bei der Trennwandung angeordnet. Diese Mittel zum Wärmetransport leiten Wärme aus dem ersten Bereich in den zweiten Bereich oder umgekehrt. Auf diese Weise lassen sich Elektrobaugruppen in einem erfindungsgemäßen Gehäuse anordnen, bei denen einzelne Bestandteile sowohl hohe Anforderungen an einen Manipulationsschutz als auch hohe Anforderungen an einen Wärmeabtransport stellen. Diese Bestandteile lassen sich dann in einem Bereich mit hoher Schutzart anordnen, während die Wärme aus diesem Bereich über die Mittel zum Wärmetransport in einen anderen Bereich des Gehäuses geleitet wird. Dieser andere Bereich kann dann beispielsweise über Lüftungslöcher die Wärme an die Umgebung abgeben.

Zum Übertragen von Wärme von einem Bauteil einer Elektrobaugruppe kann ein wärmeleitendes Material verwendet werden. Dieses kann beispielsweise durch eine Wärmeleitpaste oder eine Wärmeleitfolie realisiert sein. Das wärmeleitende Material hat dabei sowohl Kontakt zu dem wärmeerzeugenden Bauteil als auch zu dem Mittel zum Wärmetransport, das die Wärme ableitet. Entsprechende wärmeleitende Materialien und deren Anwendung sind aus der Praxis bekannt.

In einer Ausgestaltung eines Mittels zum Wärmetransport ist dieses durch einen oder mehrere Kühlkörper gebildet, der an der Trennwandung angeordnet ist und/ oder sich durch die Trennwandung erstreckt. Ein Kühlkörper, der an der Trennwandung angeordnet ist, kann über ein Wärmeleitmaterial mit der Trennwandung verbunden oder gar einstückig an der Trennwandung angeformt sein. Ein Kühlkörper, der sich durch die Trennwandung erstreckt, kann durch eine Öffnung in der Trennwandung geführt sein und ist in seiner Endposition vorzugsweise formschlüssig zu der Öffnung in der Trennwandung ausgebildet. Die Seite des Kühlkörpers für die Wärmeeingabe befindet sich dann in dem Bereich, aus dem die Wärme abtransportiert werden soll und ist beispielsweise über ein Wärmeleitmaterial mit einer integrierten Schaltung verbunden. Die Kühllamellen, Kühlrippen oder Kühlstäbe befinden sich in dem anderen Bereich und geben die aufgenommene Wärme an den anderen Bereich ab. Es wäre prinzipiell auch denkbar, einen Kühlkörper zu verwenden, der sowohl in dem einen Bereich als auch in dem anderen Bereich Lamellen aufweist. Auf diese Weise kann ein gewisser Austausch von Wärme zwischen den Bereichen realisiert werden. Der Kühlkörper kann mit der Trennwandung verklebt sein oder mit einem Halteelement, beispielsweise einer Halteklammern, an der Trennwandung gehalten sein.

Die Trennwandung kann aus einem nichtleitenden Material gefertigt sein. "Nichtleitend" bedeutet in diesem Fall elektrisch nichtleitend. Das nichtleitende Material kann dennoch Wärmeleiteigenschaften aufweisen. Das nichtleitende Material ist vorzugsweise ein Kunststoff. Dabei kann die Trennwandung aus dem gleichen Material bestehen wie das Gehäuse selbst. Der Kunststoff kann faserverstärkt sein, wie es beispielsweise bei Platinen gebräuchlich ist.

In einer bevorzugten Weiterbildung einer Trennwand aus nichtleitendem Material ist diese durch eine Platine gebildet. Diese Platine kann prinzipiell eine "aktive" Platine sein und damit Komponenten der Elektrobaugruppe tragen. Dabei wäre bei der Platzierung der Komponenten auf der Platine darauf zu achten, dass die entsprechende Berührungs- und Manipulationssicherheit gewährleistet ist. Wenn beispielsweise die Platine Bestandteile eines Sicherheitsmoduls eines SmartMeter-Gateways trägt, so sollten auf der Seite der Platine, die in den Bereich mit niedrigerer Schutzart liegen, keine hinsichtlich Manipulation gefährdeten Komponenten wie Speicherchips oder Prozessoren angeordnet sein. Vorzugsweise ist die Platine jedoch eine "passive" Platine, d.h. die Platine trägt keine Komponenten, die direkt für die Funktion der Elektrobaugruppe verantwortlich sind.

Vorzugsweise ist bei Ausgestaltung der Trennwandung durch eine Platine auf der Platine mindestens eine Leiterbahn angeordnet. Diese mindestens eine Leiterbahn kann - eine entsprechende Dimensionierung vorausgesetzt - als Mittel zum Wärmetransport verwendet werden. Zum Transport von Wärme aus einem Bereich in den anderen Bereich können Durchkontaktierungen (auch als Vias bekannt) verwendet werden, die eine Leiterbahn auf einer Seite der Platine mit einer Leiterbahn auf der anderen Seite der Platine verbinden. Zur Übertragung von Wärme auf die mindestens eine Leiterbahn können Pads ausgebildet sein, d.h. größere meist rechteckige Flächen, beispielsweise mit einer Abmessung von 1 x 1 cm². Ein wärmeleitendes Material kann mit dem Pad und einem wärmeerzeugenden Bauteil, beispielsweise einer integrierten Schaltung verbunden sein. Eine Leiterbahn auf der wärmeabgebenden Seite der Platine kann mit weiteren Mitteln zum Wärmetransport verbunden sein. So kann ein Kühlkörper auf der Leiterbahn angebracht oder mit dieser thermisch verbunden sein.

Die mindestens eine Leiterbahn auf der Platine kann zusätzlich oder alternativ eine Funktion zur Manipulationssicherung übernehmen und in einem Sicherungsbereich auf der Platine eine Detektion von Beschädigungen der Platine, beispielsweise durch Durchbohren, ermöglichen. Vorzugsweise bedeckt der Sicherungsbereich dabei mindestens 80% der Fläche der Trennwandung. Eine derartige Manipulationssicherung kann sowohl bei einer aktiven Platine als auch bei einer passiven Platine zum Einsatz kommen. Hierzu ist eine oder mehrere Leiterbahn derart in dem Sicherungsbereich angeordnet, dass keine Kreisfläche mit einem Radius größer oder gleich einem Sicherungsradius existiert, die nicht einen Teil der Leiterbahn schneidet. Dies bedeutet, dass die Leiterbahn/en derart engmaschig auf der Platine angeordnet sind, dass beispielsweise ein Bohrer mit einem Durchmesser größer dem zweifachen Sicherungsradius selbst bei optimaler Platzierung auf der Platine einen Teil der Leiterbahn beschädigt. Wenn die Leiterbahn zusätzlich mit einer Detektionsschaltung verbunden ist, kann beispielsweise aus einer Veränderung des ohmschen Widerstands auf eine (versuchte) Manipulation geschlossen werden. Diese Information kann dazu genutzt werden, dass die Detektionsschaltung die gesamte Elektrobaugruppe deaktiviert. Im Falle eines SmartMeter-Gateways kann alternativ oder ergänzend eine Meldung an das Versorgungsunternehmen gesendet werden, die beispielsweise einen Austausch des Gateways auslöst.

Dabei kann die Leiterbahn zur Manipulationssicherung im Sicherungsbereich mäander- oder spiralförmig auf der Platine angeordnet sein. Dabei kann die Anordnung innerhalb der Sicherungsbereichs auch variiert sein. So kann beispielsweise in einem Teil des Sicherungsbereichs eine mäanderförmige Anordnung, in einem anderen Teil des Sicherungsbereichs eine spiralförmige Anordnung gewählt sein. Vorzugsweise ist die Leiterbahn zur Manipulationssicherung auf der Seite der Platine angeordnet, die nicht direkt einsehbar ist. Wenn beispielsweise der erste Bereich IP3X, der zweite Bereich IP5 genügt, so kann der zweite Bereich nicht direkt eingesehen werden. In diesem Beispiel ist die Leiterbahn zur Manipulationssicherung vorzugsweise auf der dem zweiten Bereich zugewandten Seite der Platine angeordnet.

Zusätzlich oder alternativ zu einer Verwendung als Manipulationssicherung kann die mindestens eine Leiterbahn dazu verwendet werden, elektromagnetische Störeinflüsse zwischen dem ersten Bereich und dem zweiten Bereich zu reduzieren. Hierzu ist die Leiterbahn vorzugsweise auf ein Referenzpotential gelegt. In einer ganz bevorzugten Ausgestaltung ist dieses Referenzpotential ein Massepotential. Dadurch werden in der Leiterbahn induzierte Spannungen auf das Referenzpotential abgeleitet und dadurch ein EMV (Elektromagnetische Verträglichkeit)-Schutz verbessert.

Die Verbindung zu dem Referenzpotential kann über eine geeignete Schutzschaltung erfolgen.

Gemäß einer anderen Weiterbildung der Trennwandung kann diese durch ein leitfähiges Material gebildet sein. Vorzugsweise ist dieses leitfähige Material ein Metall, beispielsweise Aluminium. Da elektrisch gut leitfähige Materialien üblicherweise auch thermisch gut leitfähig sind, kann die Trennwandung selbst zu einem Mittel zum Wärmetransport werden. Auch bei dieser Ausgestaltung können Komponenten, die in besonderem Maße Wärme erzeugen, wie beispielsweise integrierte Schaltungen, direkt thermisch mit der Trennwandung verbunden sein. Hierzu kann ein wärmeleitendes Material eingesetzt werden.

Zur Verbesserung der Wärmeabgabe kann die Oberfläche der Trennwandung aus einem leitfähigen Material mit einer strukturierten Oberfläche versehen sein, die die Oberfläche der Trennwandung vergrößert. Diese Struktur bedeckt vorzugsweise einen nicht unerheblichen Anteil der Oberfläche der Trennwandung, besonders bevorzugter Weise sind mindestens 70% der Oberfläche mit einer Struktur bedeckt. Dabei ist die Struktur auf mindestens einer Seite der Trennwandung ausgebildet. Es ist aber auch denkbar, beispielsweise wenn die Struktur durch Einprägen hergestellt ist, dass beidseits der Trennwandung eine Struktur vorhanden ist. Bei Einprägen der Struktur wäre auf der einen Seite ein Negativabbild der Struktur der anderen Seite vorhanden. Vorzugsweise ist die Struktur durch Noppen und/oder Rippen gebildet. Dabei erheben sich die Strukturelemente - in den beiden bevorzugten Ausführungsbeispielen die Noppen oder Rippen - um mehrere Millimeter von der Oberfläche der Trennwandung, vorzugsweise zwischen 5 und 10 mm.

Beide Ausgestaltungen der Trennwandung, d.h. die Ausgestaltung durch ein nichtleitendes Material und durch ein leitendes Material, können auch kombiniert werden. So kann beispielsweise die Trennwandung doppelwandig sein. Hierbei kann die eine Seite aus einem leitfähigen Material bestehen und die Trennung zwischen dem ersten Bereich und dem zweiten Bereich realisieren. Auf diesem leitfähigen Teil der Trennwandung kann eine Platine angeordnet sein, die zumindest teilweise dem leitfähigen Teil der Trennwandung bedeckt. Dieser nichtleitende Teil kann beispielsweise - wie zuvor beschrieben - einen Sicherungsbereich zur zusätzlichen Manipulationssicherung aufspannen.

Prinzipiell könnte die Trennwandung relativ beliebig innerhalb des Gehäuses angeordnet sein. In einer ersten bevorzugten Anordnung ist die Trennwandung parallel zur Montagewandung des Gehäuses ausgerichtet, d.h. parallel zu der Wandung des Gehäuses, die im montierten Zustand des Gehäuses der Tragschiene zugewandt ist. In diesem Fall ist der erste Bereich an der der Montagewandung abgewandten Seite der Trennwandung ausgebildet, während der zweite Bereich zwischen Trennwandung und Montagewandung ausgebildet ist (oder umgekehrt). In einer zweiten bevorzugten Anordnung ist die Trennwandung senkrecht zu der Tragschiene ausgebildet oder - anders ausgedrückt - ist die Trennwandung senkrecht zu einer Ausdehnungsrichtung einer Aufnahme, die in der Montagewandung ausgebildet ist und in der die Tragschiene bei Montage des Gehäuses auf der Tragschiene aufgenommen wird. Damit wird das Gehäuse in Längsrichtung der Aufnahme ist zwei Bereiche unterteilt.

In einer bevorzugten Ausgestaltung weist der erste Bereich eine Schutzart mit einem IP-Code (International Protection-Code) IP3X auf bzw. die Wandungen des ersten Bereichs sind zur Einhaltung einer Schutzart mit einem IP-Code IP3X ausgebildet. Der zweite Bereich weist bei dieser bevorzugten Ausgestaltung eine Schutzart IP5X auf. Entsprechend bietet der erste Bereich einen Schutz vor festen Fremdkörpern mit einem Durchmesser ab 2,5 mm. Dadurch können die Wandungen des ersten Bereichs Lüftungsöffnungen mit einem Durchmesser von weniger als 2,5 mm aufweisen. Der zweite Bereich bietet Schutz gegenüber Staub in schädigender Menge und vollständigen Schutz gegen Berührung. Dabei wäre für einen besonders guten Schutz auch denkbar, dass der zweite Bereich vergossen ist, um diesen Bereich vollständig abzuschließen. Geeignete Vergussmaterialien sind aus der Praxis gekannt.

Eine erfindungsgemäße Kommunikationseinheit weist ein erfindungsgemäßes Gehäuse sowie eine Elektrobaugruppe auf. Dabei ist ein Teil der Elektrobaugruppe in dem ersten Bereich des Gehäuses angeordnet, während ein anderer Teil der Elektrobaugruppe in dem zweiten Bereich des Gehäuses angeordnet ist.

Vorzugsweise stellt die Kommunikationseinheit eine Verbindung zwischen mindestens zwei Netzwerken her. In einer besonders bevorzugten Ausbildung ist eines der Netzwerke ein Weitbereichsnetzwerk und ein anderes der Netzwerke ein lokales Netzwerk. Prinzipiell kann die Kommunikationseinheit verschiedenste Funktionen erfüllen. So könnte beispielsweise die Kommunikationseinheit eine Verbindung zwischen dem Internet und einer Türsprechanlage herstellen, so dass ein Nutzer über das Internet mit Personen an der Türsprechanlage kommunizieren oder das Bild einer bei der Türsprechanlage installierten Kamera einsehen kann. Vorzugsweise ist die Kommunikationseinheit jedoch ein SmartMeter-Gateway, wie es in der Einleitung näher beschrieben wurde.

Vorzugsweise sind der Teil der Elektrobaugruppe in dem ersten Bereich und der Teil der Elektrobaugruppe in dem zweiten Bereich keine voneinander losgelösten Komponenten. Vielmehr wirken die beiden Teile zusammen. So kann ein Netzteil in einem der beiden Bereiche die Elektronik in dem anderen Bereich mit Energie versorgen. Es ist auch denkbar, dass ein WAN-Interface in dem einen Bereich und ein Verschlüsselungsmodul für eine Kommunikation über das WAN-Interface in dem anderen Bereich angeordnet ist. Entsprechend sind die beiden Teile der Elektrobaugruppe in dem ersten und dem zweiten Bereich vorzugsweise untereinander mit mindestens einem elektrischen Leiter verbunden. Dieser mindestens eine elektrische Leiter erstreckt sich durch die Trennwandung und ist - insbesondere bei Ausgestaltung der Trennwandung in einem leitfähigen Material - elektrisch isoliert. Diese/r elektrische Leiter kann/können verschiedenste Funktionen erfüllen. Wie bereits angedeutet, kann eine Energieversorgung oder eine Kommunikationsmöglichkeit bereitgestellt sein.

In einer ganz besonders bevorzugten Ausgestaltung ist innerhalb des Gehäuses eine Basisplatine ausgebildet, die parallel zu und bei der Montagewandung angeordnet ist. Senkrecht zu dieser Basisplatine sind Modulplatinen angeordnet, die mit der Basisplatine verbunden sind. Hierzu können an den Modulplatinen Haltenasen oder Haltestifte ausgebildet sein, die in korrespondierende Ausnehmungen in der Basisplatine gesteckt und verlötet sind. Dabei dient die Basisplatine vorzugsweise der Kommunikation und/oder Energieübertragung zwischen den Modulplatinen. Die auf der Basisplatine hierfür vorhandenen Leiterbahnen bilden damit den zuvor genannten mindestens einen elektrischen Leiter. Die Trennwandung kann ebenso wie die Modulplatinen mit der Basisplatine verbunden sein.

Es gibt nun verschiedene Möglichkeiten, die Lehre der vorliegenden Erfindung in vorteilhafter Weise auszugestalten und weiterzubilden. Dazu ist einerseits auf die dem Anspruch 1 bzw. 13 nachgeordneten Ansprüche und andererseits auf die nachfolgende Erläuterung bevorzugter Ausführungsbeispiele der Erfindung anhand der Zeichnung zu verweisen. In Verbindung mit der Erläuterung der bevorzugten Ausführungsbeispiele der Erfindung anhand der Zeichnung werden auch im Allgemeinen bevorzugte Ausgestaltungen und Weiterbildungen der Lehre erläutert. In der Zeichnung zeigen
- Fig. 1: eine typische Installationssituation eines erfindungsgemäßen Gehäuses,
- Fig. 2: eine Seitenansicht eines erfindungsgemäßen Gehäuse,
- Fig.3: einer Draufsicht des erfindungsgemäßen Gehäuses aus Fig.2, wobei das Gehäuse geöffnet und lediglich eine Hälfte des Gehäuses dargestellt ist,
- Fig. 4: eine Schrägansicht des geöffneten Gehäuses nach Fig. 3 mit Trennwandung und einer Platine der Elektrobaugruppe,
- Fig.5: eine andere Schrägansicht des geöffneten Gehäuses nach Fig. 3 mit Trennwandung und ohne Platine,
- Fig. 6: eine Draufsicht auf das geöffnete Gehäuse nach Fig. 3 jedoch ohne Platine,
- Fig. 7: eine Schrägansicht einer ersten Ausgestaltung einer Trennwandung mit Leiterbahnen und einem Kühlkörper,
- Fig. 8: verschiedene Ansichten einer zweiten Ausgestaltung einer Trennwandung mit einem durch die Trennwandung geführten Kühlkörper und
- Fig. 9: verschiedene Ansichten einer dritten Ausgestaltung einer Trennwandung aus einem leitfähigen Material.

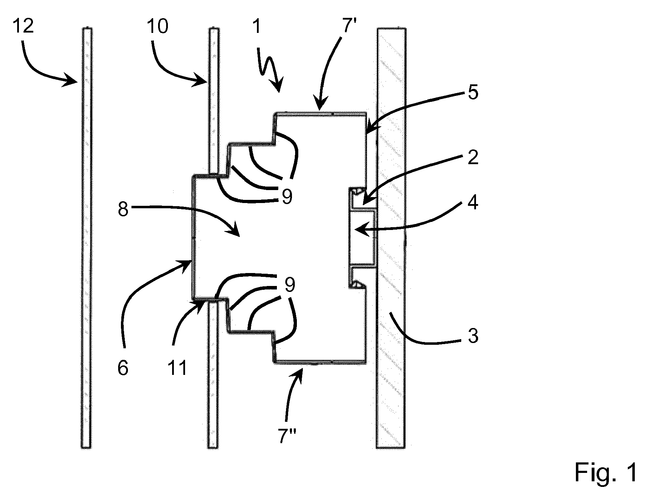

Fig. 1 zeigt eine typische Einbausituation eines erfindungsgemäßen Gehäuses 1 für eine Elektrobaugruppe beispielsweise in einem Elektroverteiler. Das Gehäuse 1, das in der dargestellten Ausführung dreistufig ausgebildet ist, weist mehrere Außenwandungen auf und ist auf einer Tragschiene 2 in Form einer Hutschiene montiert, die wiederum an einer Wand 3 angebracht ist. In einer der Außenwandungen des Gehäuses 1 ist eine Aufnahme 4 ausgebildet, die der Montage des Gehäuses 1 auf der Tragschiene 2 dient. Die Wandung, in der die Aufnahme 4 als Vertiefung ausgebildet ist und über deren gesamte Breite sich die Aufnahme 4 erstreckt, wird daher nachfolgend als Montagewandung 5 bezeichnet. Der Montagewandung 5 gegenüberliegend ist eine Frontwandung 6 ausgebildet. Des Weiteren weist das Gehäuse 1 zwei parallel zur Ausdehnungsrichtung der Aufnahme 4 und senkrecht zur Montagewandung 5 ausgerichtete Seitenwandungen 7 und zwei orthogonal zur Ausdehnungsrichtung der Aufnahme 4 verlaufende Anreihwandungen 8 auf. Mehrere weitere schmale Wandungen, die parallel zur Ausdehnungsrichtung der Aufnahme 4 und orthogonal oder parallel zu den Seitenwandungen 7 ausgerichtet sind, bilden einen gestuften Übergang zwischen den Seitenwandungen 7 und der Frontwandung 6 und werden daher nachfolgend als Stufenwandungen 9 bezeichnet. Diese Wandungen - Montagewandung 5, Frontwandung 6, Seitenwandungen 7, Anreihwandungen 8 und die Stufenwandungen 9 - begrenzen innerhalb des Gehäuses 1 einen Raum, in dem die Elektrobaugruppe angeordnet ist/werden kann.

Parallel zu der Wand 3 ist eine Berührungsschutzabdeckung 10 angeordnet, die den Bereich zwischen Berührungsschutzabdeckung 10 und Wand 3 gegenüber unberechtigtem Zugriff abschirmt. Da die Berührungsschutzabdeckung 10 üblicherweise versiegelt ist, entsteht ein gewisser Schutz vor Manipulation bzw. erfolgte oder versuchte Manipulation wird erkennbar. Die Berührungsschutzabdeckung 10 weist mindestens eine Durchführung 11 auf, durch die ein Teil des Gehäuses 1 durchgeführt ist. Dadurch bleibt die Frontwandung 6 des Gehäuses 1 sichtbar, auch wenn das Gehäuse 1 auf der Trageschiene 2 montiert und die Berührungsschutzabdeckung 10 angebracht ist. Vor der Berührungsschutzabdeckung 10 ist eine Türe 12 angeordnet, die die Anordnung abschließt.

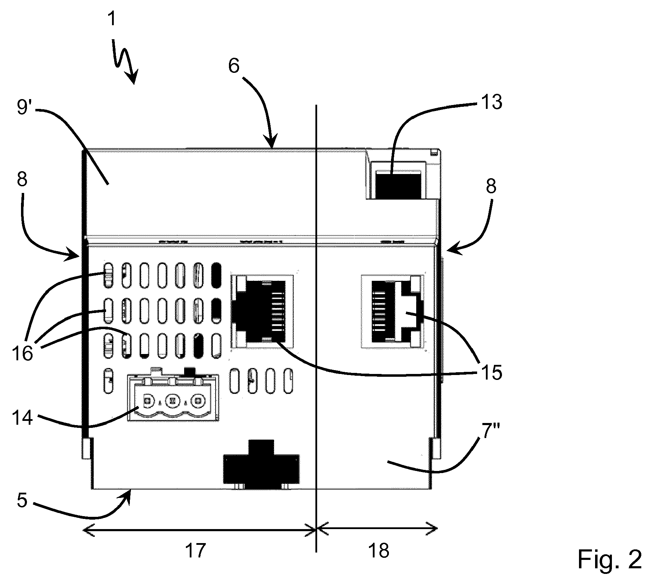

Fig. 2 zeigt eine Seitenansicht eines erfindungsgemäßen Gehäuses 1 mit Blick auf die Seitenwandung 7", wobei in dem Gehäuse eine Elektrobaugruppe zum Bilden einer Kommunikationseinheit - in diesem Fall einem SmartMeter-Gateway - angeordnet ist. Im Gegensatz zu dem Gehäuse aus Fig. 1 ist das Gehäuse 1 in Fig. 2 lediglich mit einer Stufe ausgebildet, so dass es nur zwei Stufenwandungen 9' und 9" je Seite gibt. In den Wandungen des Gehäuses 1 sind einige Öffnungen ausgebildet, durch die Buchsen der Elektrobaugruppe von außerhalb des Gehäuses 1 erreichbar sind. In der Frontseite 6 und der senkrechten Stufenwandung 9' ist eine RJ45-Buchse 13 zu erkennen, die einen Anschluss zu einem HAN (Home Area Network) bereitstellt. In der Seitenwandung 7" sind ein Stromanschluss 14 zur Energieversorgung der Kommunikationseinheit sowie zwei weitere RJ45-Buchsen 15 zu erkennen. Die rechte RJ45-Buchsen 15 kann beispielsweise einen Anschluss zu einem Powerline-Modem bereitstellen, die linke RJ45-Buchse 15 kann beispielsweise zum Anschluss eines SmartMeters dienen. Ferner sind in der Seitenwandung 7' einige Lüftungslöcher 16 eingezeichnet, durch die Wärme aus dem Inneren des Gehäuses 1 nach außen gelangen kann. Durch einige der Lüftungslöcher 16 sind angedeutete Bauteile der Elektrobaugruppe zu erkennen.

In Fig. 2 ist ferner ein senkrechter Strich eingezeichnet, der die Lage einer hier nicht erkennbaren Trennwandung im Inneren des Gehäuses andeuten soll. Links der Trennwandung (bzw. des Striches) ist ein erster Bereich 17, rechts der Trennwandung (bzw. des Striches) ist ein zweiter Bereich 18 ausgebildet. Es ist zu erkennen, dass lediglich der erste Bereich 17 über Lüftungslöcher verfügt, während der zweite Bereich 18 vollständig geschlossen ist und lediglich für Buchsen Öffnungen vorgesehen sind. Der erste Bereich ist dabei als IP3X, der zweite Bereich als IP5X ausgebildet. Zum Erzielen eines IP5X im zweiten Bereich sollten alle Öffnungen mit passenden Buchse geschlossen sein und es empfiehlt sich, den Bereich zwischen Buchse und Öffnung geeignet abzudichten, beispielsweise durch eine angespritzte Raupendichtung.

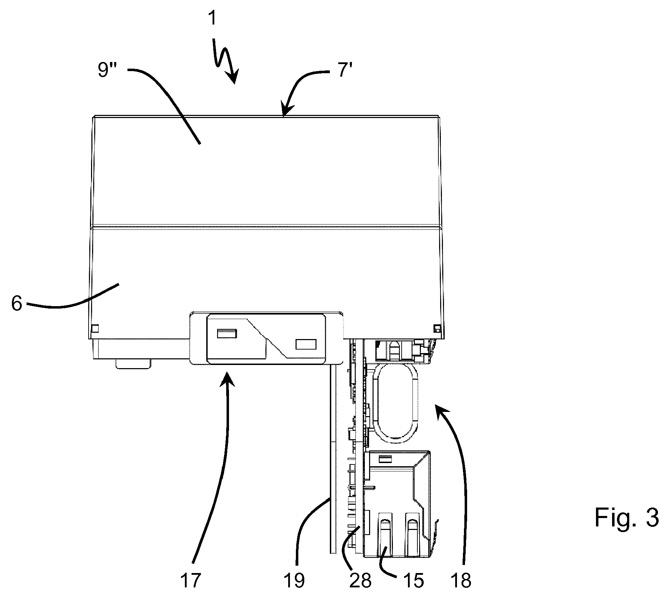

Fig. 3 zeigt eine Draufsicht aus der Gehäuse nach Fig. 2, wobei lediglich eine Hälfte des Gehäuses dargestellt ist. Das Gehäuse basiert im Wesentlichen auf dem Gehäuse, das in der deutschen Patentanmeldung 10 2014 220 169 näher beschrieben ist. In dem geöffneten Gehäuse 1 ist die Trennwandung 19 zu erkennen, die den ersten Bereich 17 von dem zweiten Bereich 18 trennt. Im zweiten Bereich 18 ist eine Platine 28 der Elektrobaugruppe angeordnet, die das HSM (Hardware Security Module) 20 des SmartMeter-Gateways implementiert.

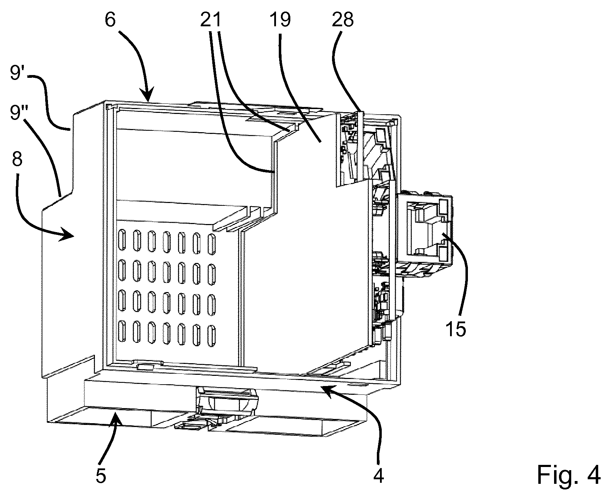

Fig. 4 stellt den gleichen Aufbau nochmals in einer Schrägansicht dar. Damit ist ein Blick ins Innere des Gehäuses möglich. Es ist zu erkennen, dass die Trennwandung 19 in Führungsschienen 21 eingesteckt ist, die an der Innenseite einiger Außenwandungen des Gehäuses 1 angeformt sind. Ferner ist zu erkennen, dass sich die Trennwandung 19 bis zu allen Außenwandungen des Gehäuses erstreckt, die die Ebene der Trennwandung 19 schneiden. Die Trennwandung 19 erstreckt sich daher von der Montagewandung 5 zur Frontwandung 6, von der einen Seitenwandung 7' zur anderen Seitenwandung 7" und folgt zudem dem Verlauf der Stufenwandungen 9' und 9". Damit trennt die Trennwandung 19 den ersten Bereich 17 vollständig von dem zweiten Bereich 18.

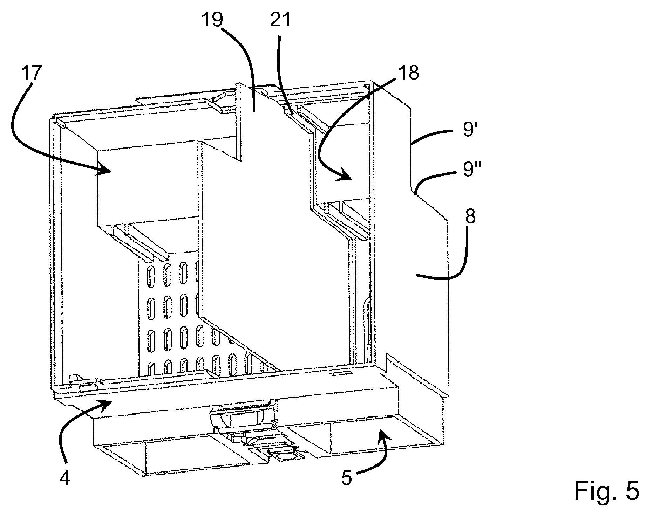

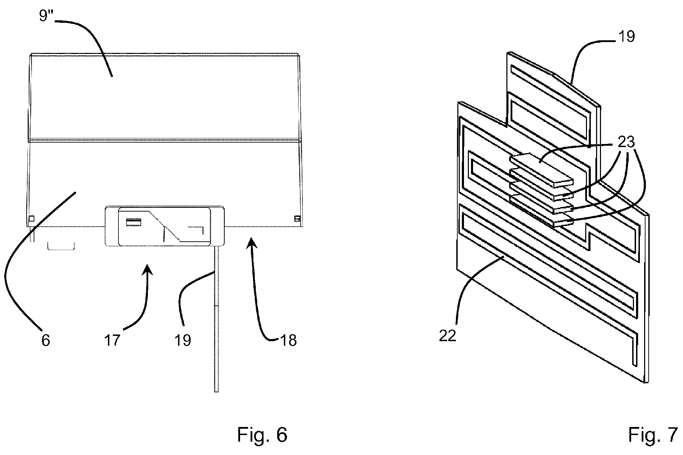

In Fig. 5 ist eine andere Schrägansicht des Gehäuses aus Fig. 4 dargestellt, wobei hier die Platine des HSM 20 der Übersichtlichkeit wegen nicht enthalten ist. In Fig. 6 ist eine Draufsicht auf das Gehäuse dargestellt.

Die Fig. 7 bis 9 zeigen verschiedene Ausgestaltungen einer Trennwandung, wie sie in einem erfindungsgemäßen Gehäuse bzw. einer erfindungsgemäßen Kommunikationseinheit vorhanden sein können. Fig. 7 zeigt eine erste Ausgestaltung einer Trennwandung. Die Trennwandung 19 ist aus einem nichtleitenden Material gebildet und ist in der dargestellten Ausführung als Platine ausgebildet. Auf der Platine ist eine mäanderförmige Leiterbahn 22 aufgebracht. Die Leiterbahn 22 kann als Mittel zum Wärmetransport genutzt werden. Auf der in Fig. 7 hinten liegenden Seite der Trennwandung kann ebenso eine Leiterbahn aufgebracht sein, die mit einer oder mehreren Durchkontaktierungen mit der in Fig. 7 sichtbaren Leiterbahn 22 verbunden ist. In Fig. 7 ebenso dargestellt sind Kühllamellen 23, die ebenso ein Mittel zum Wärmetransport bilden können und Wärme an die Umgebung abgeben. Die Kühllamellen können mit der Leiterbahn 22 thermisch leitend verbunden sein.

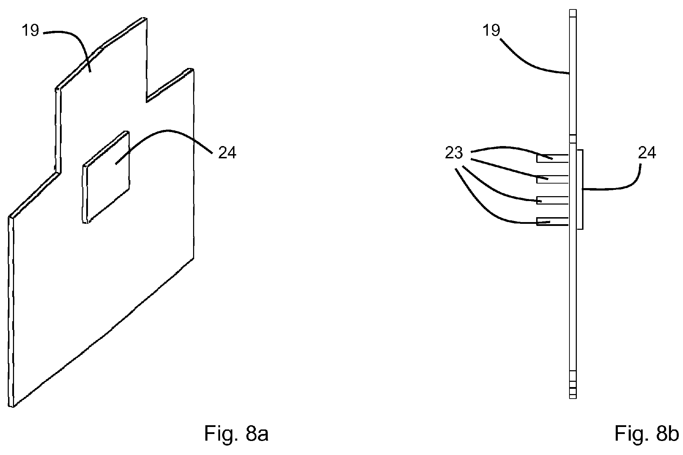

Fig. 8 zeigt eine zweite Ausgestaltung einer Trennwandung, wobei Fig. 8a eine Schrägansicht und Fig. 8b eine Seitenansicht der Trennwandung 19 darstellt. Die Trennwandung 19 ist aus einem nichtleitenden Material gebildet. Durch Öffnungen in der Trennwandung 19 sind Kühllamellen 23 eines Kühlkörpers 24 gesteckt. Eine Verklebung hält den Kühlkörper auf der Trennwandung fest und dichtet die Trennwandung geeignet ab. Die Eingabeseite des Kühlkörpers 24 ist in Fig. 8a als Rechteck zu erkennen. Mit dieser Eingabeseite kann eine integrierte Schaltung, wie beispielsweise ein Mikroprozessor, thermisch verbunden sein, beispielsweise über ein Wärmeleitfolie oder ein anderes wärmeleitendes Material. Die Kühllamellen 23 des Kühlkörpers 24 bilden die Abgabeseite und geben die an der Eingabeseite aufgenommene Wärme auf der anderen Seite der Trennwandung wieder ab. Wenn in Fig. 8b der erste Bereich links der Trennwandung und der zweite Bereich rechts der Trennwandung gebildet ist, würde der Kühlkörper Wärme aus dem zweiten Bereich in den ersten Bereich leiten können.

Die Ausgestaltungen der Trennwandungen nach Fig. 7 und nach Fig. 8 können auch kombiniert werden. In diesem Fall wären die Lamellen 23, die in Fig. 8 zu erkennen sind, die Kühllamellen des Kühlkörpers 24. Dabei kann die Leiterbahn 22 auch nicht direkt mit dem Kühlkörper verbunden sein. Damit wären zwei unabhängige Mittel zum Wärmetransport vorhanden.

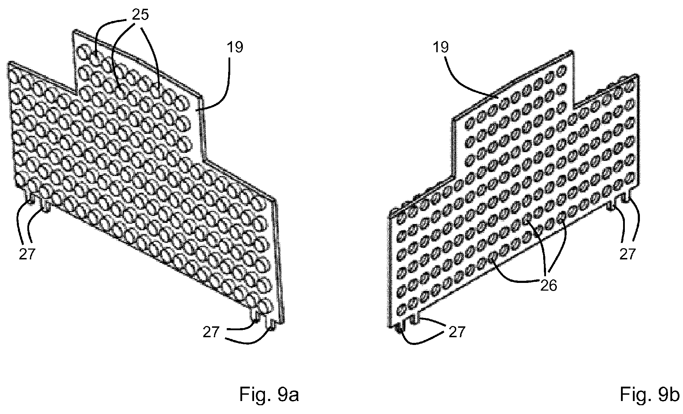

Fig. 9a und 9b zeigen Schrägansichten einer dritten Ausgestaltung einer Trennwandung 19. In dieser Ausgestaltung ist die Trennwandung 19 aus einem leitfähigen Material gebildet ist. Damit stellt die Trennwandung 19 selbst ein Mittel zum Wärmetransport dar, mit der Wärme aus dem einen angrenzenden Bereich in den anderen angrenzenden Bereich geleitet werden kann. Zur Erhöhung der Oberfläche sind Noppen 25 in die Trennwandung 19 eingeprägt. Daher sind die in Fig. 9b erkennbaren Vertiefungen 26 das Negativabbild der Noppen 25 aus Fig. 9a. Die Trennwandung ist - wie bei allen zuvor beschriebenen Ausgestaltungen - der Form der Innenseite der Wandungen des Gehäuses nachempfunden. An der Unterseite der Trennwandung sind Haltestifte 27 ausgebildet, die in korrespondierende Löcher in einer Basisplatine, die orthogonal zu der Trennwandung angeordnet wäre, eingesteckt werden könnten. Zur Befestigung könnten die Haltestifte dann mit Leiterbahnen auf der Basisplatine verlötet werden, wobei diese Leiterbahnen zusätzlich eine Verbindung zu einem Referenzpotential, beispielsweise Masse, bereitstellen können.

Hinsichtlich weiterer vorteilhafter Ausgestaltungen des erfindungsgemäßen Gehäuses bzw. der erfindungsgemäßen Kommunikationseinheit wird zur Vermeidung von Wiederholungen auf den allgemeinen Teil der Beschreibung sowie auf die beigefügten Ansprüche verwiesen.

Schließlich sei ausdrücklich darauf hingewiesen, dass die voranstehend beschriebenen Ausführungsbeispiele des erfindungsgemäßen Gehäuses bzw. der erfindungsgemäßen Kommunikationseinheit lediglich zur Erörterung der beanspruchten Lehre dienen, diese jedoch nicht auf die Ausführungsbeispiele einschränken.

### Bezugszeichenliste

- 1: Gehäuse
- 2: Trageschiene
- 3: Wand
- 4: Aufnahme
- 5: Montagewandung
- 6: Frontwandung
- 7: Seitenwandung
- 8: Anreihwandung
- 9: Stufenwandung
- 10: Berührungsschutzabdeckung
- 11: Durchführung
- 12: Türe
- 13: RJ45-Buchse
- 14: Stromanschluss
- 15: RJ45-Buchsen
- 16: Lüftungslöcher
- 17: Erster Bereich
- 18: Zweiter Bereich
- 19: Trennwandung
- 20: HSM (Hardware Security Module)
- 21: Führungsschienen
- 22: Leiterbahn
- 23: Kühllamellen
- 24: Kühlkörper
- 25: Noppen
- 26: Vertiefungen
- 27: Haltestifte
- 28: Platine

## Patentansprüche

1. Gehäuse für eine Elektrobaugruppe, insbesondere für ein SmartMeter-Gateway, zur Montage auf einer Trageschiene (2), insbesondere auf einer Hutschiene, wobei das Gehäuse (1) mehrere Außenwandungen (5, 6, 7, 8, 9) aufweist, die gemeinsam einen Raum innerhalb des Gehäuses (1) begrenzen,
**dadurch gekennzeichnet, dass** in dem Gehäuse (1) eine Trennwandung (19) angeordnet ist, die sich von einer der mehreren Außenwandungen (5, 6, 7, 8, 9) zu einer anderen der mehreren Außenwandungen (5, 6, 7, 8, 9) erstreckt und die den durch die mehreren Außenwandungen (5, 6, 7, 8, 9) begrenzten Raum in einen ersten Bereich (17) und einen zweiten Bereich (18) unterteilt, und dass die den ersten Bereich (17) begrenzenden Wandungen (5, 6, 7, 8, 9, 19) zum Einhalten einer ersten Schutzart und die den zweiten Bereich (18) begrenzenden Wandungen (5, 6, 7, 8, 9, 19) zum Einhalten einer zweiten Schutzart ausgebildet sind, wobei die erste Schutzart ungleich der zweiten Schutzart ist.

2. Gehäuse nach Anspruch 1, **dadurch gekennzeichnet, dass** die Trennwandung (19) Mittel zum Wärmetransport aufweist und/oder dass bei der Trennwandung (19) Mittel zum Wärmetransport angeordnet sind, wobei die Mittel zum Wärmetransport Wärme von dem ersten Bereich (17) in den zweiten Bereich (18) oder umgekehrt leiten.

3. Gehäuse nach Anspruch 2, **dadurch gekennzeichnet, dass** die Mittel zum Wärmetransport durch mindestens einen Kühlkörper (24) gebildet sind, wobei der mindestens eine Kühlkörper (24) an der Trennwandung (19) angeordnet ist und/ oder sich zumindest teilweise durch die Trennwandung (19) erstreckt.

4. Gehäuse nach einem der Ansprüche 1 bis 3, **dadurch gekennzeichnet, dass** die Trennwandung (19) aus einem nichtleitenden Material, vorzugsweise einem Kunststoff, besteht.

5. Gehäuse nach Anspruch 4, **dadurch gekennzeichnet, dass** die Trennwandung (19) durch eine Platine ausgebildet ist, wobei auf der Platine mindestens eine Leiterbahn (22) angeordnet ist.

6. Gehäuse nach Anspruch 2 und 5, **dadurch gekennzeichnet, dass** die mindestens eine Leiterbahn (22) ein Mittel zum Wärmetransport bildet, wobei zum Transport von Wärme zwischen dem ersten und dem zweiten Bereich (17, 18) Durchkontaktierungen vorhanden sind, die eine Leiterbahn auf einer Seite der Platine mit einer Leiterbahn auf der anderen Seite der Platine verbinden.

7. Gehäuse nach Anspruch 5 oder 6, **dadurch gekennzeichnet, dass** die mindestens eine Leiterbahn (22) zumindest teilweise in einem Sicherungsbereich auf der Trennwandung (19) angeordnet ist, wobei die Leiterbahn in dem Sicherungsbereich derart ausgebildet ist, dass in dem Sicherungsbereich keine Kreisfläche mit einem Radius größer oder gleich einem Sicherungsradius existiert, die nicht einen Teil der Leiterbahn schneidet, und wobei der Sicherungsbereich vorzugsweise mindestens 80% der Fläche der Trennwandung bedeckt.

8. Gehäuse nach einem der Ansprüche 5 bis 7, **dadurch gekennzeichnet, dass** die mindestens eine Leiterbahn (22) mäander- oder spiralförmig über die Platine verläuft.

9. Gehäuse nach einem der Ansprüche 5 bis 8, **dadurch gekennzeichnet, dass** die mindestens eine Leiterbahn (22) zur Abschwächung von elektromagnetischen Störeinflüssen zwischen dem ersten Bereich (17) und dem zweiten Bereich (18) mit einem Referenzpotential, vorzugsweise mit Masse, verbunden ist.

10. Gehäuse nach einem der Ansprüche 1 bis 3, **dadurch gekennzeichnet, dass** die Trennwandung (19) durch ein leitfähiges Material, vorzugsweise ein Metall, gebildet ist, wodurch die Trennwandung (19) selbst ein Mittel zum Wärmetransport bildet, wobei die Trennwandung (19) vorzugsweise auf ein Referenzpotential, besonders bevorzugter Weise auf Masse, gelegt ist, wobei die Trennwandung (19) zur Vergrößerung der für einen Wärmetransport wirksamen Oberfläche vorzugsweise zumindest auf einer Seite eine Struktur aufweist, die besonders bevorzugter Weise durch Noppen (25) und/oder Rippen gebildet ist.

11. Gehäuse nach einem der Ansprüche 1 bis 10, **dadurch gekennzeichnet, dass** an einer der mehreren Außenwandungen (5) eine Aufnahme (4) für die Tragschiene (2) ausgebildet ist und dass die Trennwandung (19) parallel oder orthogonal zu einer Ausdehnungsrichtung der Aufnahme (4) ausgerichtet ist.

12. Gehäuse nach einem der Ansprüche 1 bis 11, **dadurch gekennzeichnet, dass** die erste und die zweite Schutzart durch die Größe von Zugängen in den Wandungen (5, 6, 7, 8, 9, 19) des ersten Bereichs (17) bzw. des zweiten Bereichs (18) definiert ist, wobei die erste Schutzart vorzugsweise durch den International Protection-Code IP3X und die zweiten Schutzart vorzugsweise durch den International Protection-Code IP5X beschrieben ist.

13. Kommunikationseinheit mit einem Gehäuse nach einem der Ansprüche 1 bis 12 und einer in dem Gehäuse (1) angeordneten Elektrobaugruppe, wobei in dem ersten Bereich (14) und in dem zweiten Bereich (15) jeweils zumindest Teile der Elektrobaugruppe angeordnet sind, wobei die Elektrobaugruppe vorzugsweise auf mehreren Platinen (28) aufgebaut ist.

14. Kommunikationseinheit nach Anspruch 13, **dadurch gekennzeichnet, dass** die Kommunikationseinheit eine Verbindung zwischen zwei Netzwerken herstellt, insbesondere einem lokalen Netzwerk und einem Weitbereichsnetzwerk, und dass die Kommunikationseinheit vorzugsweise ein SmartMeter-Gateway ist.

15. Kommunikationseinheit nach Anspruch 13 oder 14, **dadurch gekennzeichnet, dass** der in dem ersten Bereich (17) angeordnete Teil der Elektrobaugruppe und der in dem zweiten Bereich (18) angeordnete Teil der Elektrobaugruppe über mindestens einen elektrischen Leiter untereinander verbunden sind, wobei sich der elektrische Leiter durch die Trennwandung (19) erstreckt.
